# EUROPEAN PATENT SPECIFICATION

(11) **EP 0 390 509 B1**
(45) Date of publication and mention of the grant of the patent: **01.07.1998**
(21) Application number: 90303269.6
(22) Date of filing: 28.03.1990
(51) Int. Cl.: H01L 21/336, H01L 21/28

(54) **Semi-conductor device and method of manufacturing the same**
Halbleiterbauelement und Verfahren zu dessen Herstellung
Elément semi-conducteur et procédé pour sa réalisation

(30) Priority: 28.03.1989 JP 76108/89; 28.03.1989 JP 76109/89; 20.02.1990 JP 38757/90
(43) Date of publication of application: 03.10.1990
(73) Proprietor: SEIKO EPSON CORPORATION, Shinjuku-ku Tokyo (JP)
(72) Inventor: Takeuchi, Masahiro c/o SEIKO EPSON COPORATION, Suwa-shi Nagano-ken (JP)
(74) Representative: Sturt, Clifford Mark

(56) References cited:
- IEEE TRANSACTIONS ON ELECTRON DEVICES, vol. ED-31, no. 10, October 1984, pages 1432-1439, IEEE, New York, US; M. FUKUMOTO et al.: "A new MoSi2/Thin poly-Si gate process technology without dielectric degradation of a gate oxide"
- IBM TECHNICAL DISCLOSURE BULLETIN, vol. 24, no. 8, January 1982, pages 4186- 4187, New York, US; E. ADLER: "Combined shallow and deep junction self-aligned MOSFET process"
- IEEE INTERNATIONAL ELECTRON DEVICES MEETING, Washington, D.C., 6th - 9th December 1987, pages 38-41, IEEE, New York,US; R. IZAWA et al.:"The impact of gate-drain overlapped LDD (gold) for deep submicron VLSI'S"
- IEEE TRANSACTIONS ON ELECTRON DEVICES, vol. ED-30, no. 11, November 1983, pages 1480-1497, IEEE, New York, US; T.P. CHOW et al.: "Refractory metal silicides: Thin-film properties and processing technology"
- IEEE ELECTRON DEVICE LETTERS, vol. EDL-8, no. 10, October 1987, pages 463-466, IEEE, New York, US; G.A. SAI-HALASZ et al.: "Design and experimental technology for 0.1-mum gate-length low-temperature operation FET's"
- VLSI ELECTRONICS MICROSTRUCTURE SCIENCE, Vol. 15, VLSI Metallisation, Ed. N.G.Einspruch, Academic Press 1987, pages 228-239
- Silicides for VLSI Applications, S.P.Makura, Academic Press 1983, pages 120-121.

## Description

The present invention is directed to a semi-conductor device; and to a method of manufacturing such a device.

As semi-conductor devices have been developed to have a hyperfine structure and high integration, the configuration of MOS transistors for use in semi-conductor devices has also become hyperfine. The minuteness of the component dimensions, however, causes a problem in that a deterioration in performance associated with hot carriers tends to occur. In order to obviate this problem, a structure known as LDD (lightly doped drain) was proposed. An improvement on the LDD structure is disclosed in pp. 38 to 41 of "The Impact of Gate-Drain Overlapped LDD (Gold) For Deep Sub-Micron VLSI'S", IEDM Tech. Dig. written by R. Izawa, T. Kure and E. Takeda, published in 1987. A manufacturing method reported in this document will be described below with reference to Figure 2.

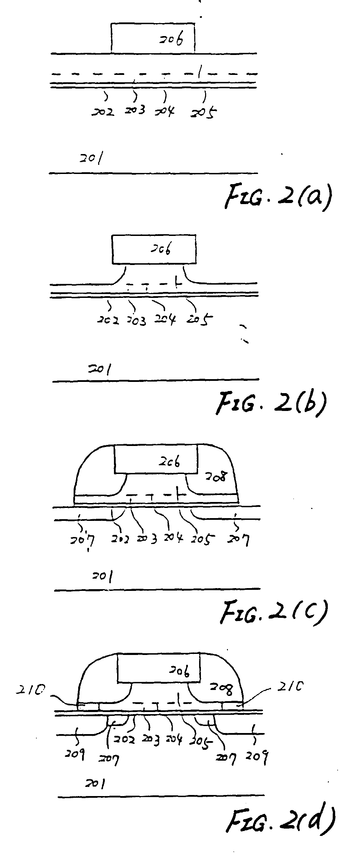

Referring to Figure 2 (d), a semi-conductor device produced by this method comprises a p-type semi-conductor substrate 201, a gate oxide film 202, a polysilicon film 203, a natural oxide film 204, a polysilicon film 205, a silicon oxide film 206, an n-type impurity layer 207 having low concentration, an insulating side wall 208 in the form of an oxide film, an n-type impurity layer 209 having a high concentration, and an oxide film 210. The polysilicon films 203, 205 constitute a gate electrode, and the impurity layers 207, 209 constitute source/drain regions.

To start with, the p-type semi-conductor substrate 201 undergoes thermal oxidisation to form the gate oxide film 202. Next, the polysilicon film 203 is deposited as a thin layer by the CVD method and the vapour is thereafter left in the air, thus forming the natural oxide film 204 to a thickness of 5.10⁻¹⁰m to 10.10⁻¹⁰m (5Å to 10Å). Subsequently, the polysilicon film 205 and the silicon oxide film 206 are sequentially deposited by the CVD method. As illustrated in Figure 2(a), unnecessary portions of the silicon oxide film 206 are eliminated by photoetching.

Dry etching is then effected with the oxide film 206 serving as a mask, thereby removing the unnecessary portions of the polysilicon film 205 as shown in Figure 2(b).

The n-type impurity layer 207 is formed by ion implantation of an n-type impurity, ie. phosphorus, using the silicon oxide film 206 and the polysilicon film 205 as a mask, as illustrated in Figure 2(c). The side wall insulating film 208 is formed by first depositing silicon oxide film by the CVD method and then dry etching.

As depicted in Figure 2(d) oxidisation is carried out at 800°C in a wet atmosphere, to form the oxide film 210. Subsequently, the n-type impurity layer 209 is formed by effecting ion implantation on an n-type impurity, viz. arsenic, with the polysilicon film 203, oxide film 206 and side wall insulating film 208 serving as a mask.

The following problems are, however, inherent in the above mentioned prior art process. Although the properties of the MOS transistor largely vary depending on the lateral extent of the oxide film 210, it is difficult to control the dimensions thereof, because the lateral extent is determined by the thickness of the polysilicon film 203 and by oxidising conditions in the wet atmosphere. In particular, when the gate length of the MOS transistor is in the region as minute as a sub-micron, remarkable fluctuations occur in the transistor properties due to variation in the lateral dimensions of the oxide film 210.

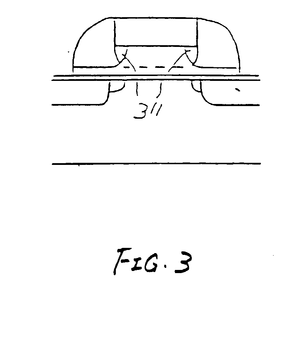

Furthermore, when depositing the silicon oxide film 208 by the CVD method, the oxide film 206 over-hangs the polysilicon film 205, and hence, as illustrated in Figure 3, it is hard for the silicon oxide film 208 to cover this region, resulting in the formation of voids. This leads to a deterioration in moisture resistance of the MOS transistor.

The prior art described above also presents additional problems. When forming the MOS transistor, the combined thickness of the films disposed on the channel region - ie. the gate oxide film 202, the polysilicon film 203, the natural oxide film 204, the polysilicon film 205 and the silicon oxide film 206 - amount to a large step. Consequently, a metallisation layer formed on the gate electrode for lead purposes is in some cases disrupted or disconnected due to the size of the above mentioned step; or alternatively the metallisation layer is short circuited because portions of the layer remain unetched when forming the layer on the gate electrode.

IBM Technical Disclosure Bulletin, Vol. 24, No. 8, January 1982 pgs 4186 - 4187 disclose a method of manufacturing a semi-conductor device in which gate electrode layers are provided, source drain regions are then formed by ion implantation, and thereafter the device is subjected to an oxidation and drive in step.

The present invention seeks to overcome the above problems.

According to the present invention, there is provided a method of manufacturing a semi-conductor device comprising:
a) providing a semi-conductor substrate of a first conductivity type;
b) forming a gate electrode on the semi-conductor substrate including a first conductive layer and a second conductive layer superposed thereon, said first conductive layer including polysilicon material and said second conductive layer including refractory metal;
c) ion-implanting impurities of a second conductivity type into the semi-conductor substrate to form source/drain regions using the first and second conductive layer as a mask; and
characterised in that between steps (b) and (c) thermal annealing is performed to contract the second conductive layer relative to the first conductive layer.

In an embodiment of the present invention the method of manufacturing a semi-conductor device comprises the steps of: forming a first insulating film on a first conductivity type semi-conductor substrate; forming a first conductive film on the first insulating film; sequentially forming a second conductive film on the first conductive film; forming a MOS transistor gate electrode by use of the first and second conductive films; effecting thermal annealing thereon; performing ion implantation of first impurities of a second conductivity type into the semi-conductor substrate with the gate electrode serving as a mask; forming a side wall insulating film on the gate electrode by use of a second insulating film by effecting an isotropic ion etching after forming the second insulating film on the gate electrode as well as on the semi-conductor substrate; and introducing second impurities of the second conductivity type preferably using ion implantation with the gate electrode and the side wall insulating film serving as a mask.

In this method, when performing the ion implantation of the first impurities of the second conductivity type, the kind of ions implanted and the ion implantation acceleration energy may be so set that the ions cannot pass through the combined thickness of the first and second conductive films but can pass through the thickness of the first conductive film alone.

Preferably, the depth of a region of the second ion implanted impurities of the second conductivity type is less than that of a region of the first ion implanted impurities of the second conductivity type.

In the embodiment described below, the first conductive film is a polysilicon film, and the second conductive film is a refractory metal film or a refractory metal silicide film.

The invention will be described further, by way of example, with reference to the accompanying drawings, in which:-
Figures 1(a) to 1(f) are sectional views showing the sequence of steps in a method of manufacturing a semi-conductor device according to one embodiment of the present invention;
Figures 2(a) to 2(d) are sectional views showing the sequence of steps in a method of manufacturing a prior art semi-conductor device; and
Figure 3 is a sectional view through the prior art semi-conductor device of Figures 2 showing the formation of voids therein.

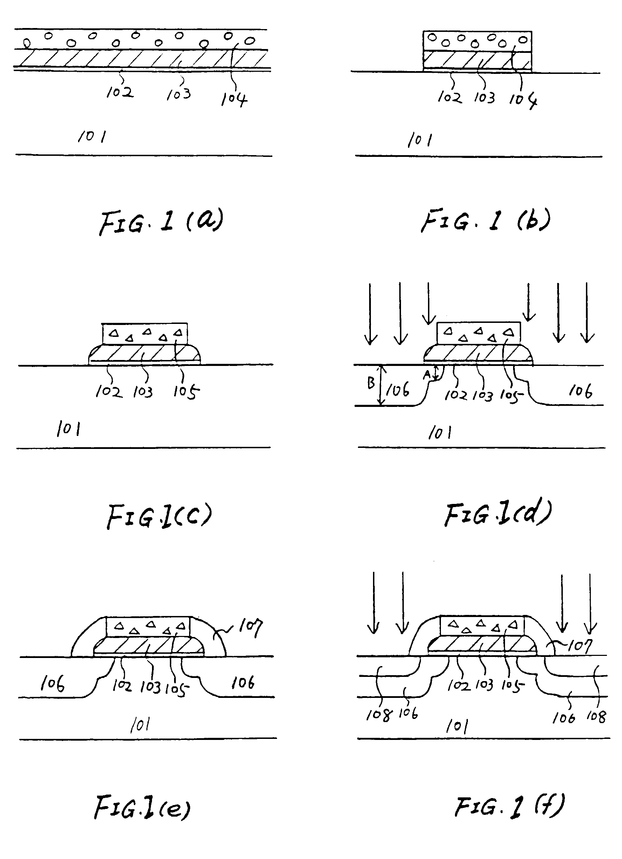

An embodiment of the present invention will be described with reference to Figures 1(a) to 1(f). To start with, as depicted in Figure 1(a), a first conductivity type semi-conductor substrate or p-type silicon substrate 101 doped with boron is oxidised at 1000°C in an oxidative atmosphere, thereby forming a gate oxide film 102 having a thickness of 150.10⁻¹⁰m (150Å). Subsequently, a polysilicon film 103 is deposited up to a thickness of 1000.10⁻¹⁰m to 3000.10⁻¹⁰m (1000Å to 3000Å) by the CVD method, and phosphorus is added as dopant to a level of more than 10¹⁹cm⁻³ by thermal diffusion. Thereafter, a refractory metal film, in this instance a molybdenum film, 104 is formed to a thickness of 1500.10⁻¹⁰m to 4000.10⁻¹⁰m (1500Å to 4000Å) by sputtering.

Unnecessary portions of the polysilicon film 103 and of the molybdenum film 104 are, as illustrated in Figure 1(b), eliminated by photo-etching, thus forming a gate electrode of a MOS transistor.

Thermal annealing is then effected at 850°C to 1100°C, with the result that the molybdenum film 104 reacts with the polysilicon film 103 disposed thereunder to form a molybdenum silicide film 105 as shown in Figure 1(c). At this time, the volume of the molybdenum silicide film 105 is reduced by comparison with that of the above mentioned molybdenum film 104. A typical reduction in volume for the molybdenum silicide (MoSi₂) is 27%. In a modification of the present embodiment, the molybdenum may be replaced by another refractory metal such as tungsten, tantalum or titanium and in these cases typical rates of volume reduction are as follows: tungsten silicide (WSi₂) 27%; tantalum silicide (TaSi₂) 25%; and titanium silicide (TiSi₂) 23%. In the gate electrode of this embodiment, which is composed of molybdenum polycide, only the molybdenum silicide film 105 of the gate electrode contracts in bi-lateral directions as shown in Figure 1(c). In this embodiment, the degree of contraction, as a total on both sides of the gate electrode, ranges from 0.05 µm to 0.2 µm on the assumption that gate length after etching the MOS transistor is 0.8 µm. Hence, the dimension of the molybdenum silicide film 105 disposed on the polysilicon film 103 after effecting thermal annealing is from 0.6 µm to 0.75 µm. The amount of contraction can readily be controlled with high accuracy, simply by changing the thicknesses of the polysilicon film 103 and the molybdenum film 104, and also the thermal annealing temperature after forming the gate electrode.

Next, as illustrated in Figure 1 (d), ion implantation of n-type impurities, in this instance phosphorus is carried out under conditions of an accelerating voltage set to be from 80 KeV to 200 KeV, and a dose set to be from 5 x 10¹² cm⁻² to 5 x 10¹⁴ cm⁻². As a result, the phosphorus is not implanted into the silicon substrate underneath the portion of the gate electrode composed of the polysilicon film 103 and the molybdenum silicide film 105, whereas the phosphorus is implanted shallowly into the silicon substrate under the portion of the gate electrode composed of the polysilicon film 103 in the region where the molybdenum silicide film 105 has contracted. Additionally, the phosphorus is implanted deeply into the silicon substrate in the source/drain regions in which no gate electrode exists, thereby forming an n-type impurity layer 106 having a low impurity concentration as shown in Figure 1 (d).

A specific example of the above embodiment will now be given: the gate oxide film 102 is formed to a thickness of 150Å (1A = 0.1 nm); the polysilicon film 103 is 2000Å in thickness; and the molybdenum film 104 is 2500Å thick. Subsequently, an isotropic etching is effected such that the length of the gate electrode of the MOS transistor comes to 0.8 µm; and thermal annealing is performed at 1000°C, thereby forming the molybdenum silicide film 105. At this time, the molybdenum silicide film contracts bilaterally by 0.1 µm on both sides, whereby the length thereof becomes approximately 0.6 µm. Then, the ion implantation of the phosphorus is effected, the accelerating voltage being set to 160 KeV, and the dose being set to be 3 x 10¹³cm⁻². The phosphorus is not implanted into a channel region of the silicon substrate provided beneath the portion of the gate electrode consisting of the polysilicon film 103 and of the molybdenum silicide film 105, whereas the phosphorus is implanted shallowly into the silicon substrate under the portion of the gate electrode consisting of the polysilicon film 103 alone in the area where the molybdenum silicide film has contracted. In the latter region, a junction depth A is approximately 0.2 µm; a peak depth of the impurity concentration distribution of phosphorus is about 0.05 µm; and the concentration thereof is nearly 1 x 10¹⁸ cm⁻³. In the source/drain regions wherein no gate electrode is provided, the phosphorus is implanted deep into the silicon substrate. Here, a junction depth B is approximately 0.4 µm; a peak depth of the impurity concentration distribution of phosphorus is about 0.25 µm; and the concentration thereof is nearly 1 x 10¹⁸ cm⁻³. It is additionally stated that such data on the profile of the impurity is obtained after effecting annealing at 950°C for twenty minutes.

The transistor described above and produced as shown in Figures 1 (a) to 1 (d) functions. However, the following steps have the advantage of decreasing sheet resistances of the source/drain regions.

As depicted in Figure 1 (e), a silicon oxide film is deposited to a thickness of 4000Å to 8000Å on the gate electrode as well as on the silicon substrate by the CVD method, and thereafter reactive ion etching is carried out to form a side wall oxide film 107.

Subsequently, as shown in Figure 1 (f), ion implantation of n-type impurities, e.g. arsenic in this embodiment, is performed under conditions of an accelerating voltage set to be 50 KeV to 150 KeV, and a dose set to be 1 x 10¹⁵ cm⁻² to 1 x 10¹⁶ cm⁻²; and thermal annealing is then effected at 900°C to 1000°C, thereby forming an n-type impurity layer 108 having a high impurity concentration. Note that the n-type impurity layer 108 may be formed likewise without shaping the side wall oxide film 107.

The MOS transistor constructed in accordance with the above described steps have a gate electrode, in which the polysilicon film 103 overlaps the n-type impurity layer 106 having a low concentration, and hence, if a voltage is impressed on the gate, an apparent resistance of the low concentration n-type impurity layer 106 is reduced due to its electric field. On the other hand, a crosswise electric field within the low concentration n-type impurity layer 106 is relieved. This results in an increment in drain current of the transistor, and it is therefore possible to avoid a deterioration of conductance associated with hot carriers.

In accordance with the present invention, the properties of the MOS transistor largely vary depending on the overlap of the polysilicon film 103 of the gate electrode and the low concentration n-type impurity layer 106, but this can be controlled with high accuracy and facility simply by changing the thicknesses of the polysilicon film 103 and of the molybdenum film 104 and also the thermal annealing temperature after forming the gate electrode. Hence, scatter in the properties of the MOS transistor is reduced.

In the described embodiment, there exists no overhang between the molybdenum silicide film 105 and the polysilicon film 103. Consequently, no voids are formed, and there is no decline in the moisture resistance of the transistor.

Moreover, in the embodiment of the present invention described above, the film thickness on the channel region is merely the sum of the thicknesses of the gate oxide film 102, the polysilicon film 103, and the molybdenum silicide film 105. Hence, only a small step is created and a metallisation layer may be formed on the gate electrode to traverse the gate electrode without resulting in a short circuit due to portions of the metal remaining unetched when forming the metallisation layer on the gate electrode.

In the described embodiment, the refractory metal film 104 disposed on the polysilicon film 103 comprises molybdenum. The same effects can, however, be expected by employing tungsten, titanium, platinum, cobalt, nickel and tantalum; and refractory metal silicide films thereof may also be used.

The embodiment given above features a case where phosphorus is employed as the n-type impurity for the low concentration n-type impurity layer 106. The impurity may, however, include arsenic and antimony; and it may be provided by a combination of these impurities, e.g. phosphorus and arsenic. The embodiment discussed above also features a case where arsenic is employed as the n-type impurity for the high concentration n-type impurity layer 108. However, phosphorus and antimony are likewise available; and combinations of impurities may be used. Furthermore, in this embodiment boron is employed as the impurity for the p-type semi-conductor substrate, but gallium, aluminium and indium may also be used.

The above description focuses on an n-channel MOS transistor. As a matter of course, the present invention may also be applied to a p-channel MOS transistor.

According to the present invention, the drain current of the MOS transistor increases, and it is possible to avoid a deterioration of conductance which is due to the hot carriers. Thus, a high speed and highly reliable MOS transistor can be provided.

In accordance with the present invention, it is possible to control, with high accuracy but less scatter, the length of the overlap of the gate electrode with the source/drain regions associated with the low concentration impurity layer, on which the properties of the MOS transistor depend. It is therefore possible to reduce scatter of the conductance and of the drain current of the MOS transistor.

In accordance with the described embodiment, the moisture resistance of the MOS transistor is not diminished.

The present invention as described exhibits the additional advantage of minimising the likelihood of short circuit and disruption of the metallisation layer on the gate electrode.

Consequently, the present invention may provide a semi-conductor device in which there is no short circuit or disruption of a metallisation layer formed on a gate electrode, which exhibits less scatter in the properties of the transistor and which has good moisture resistance. The invention may thus provide a high speed semi-conductor device having a high quality, high reliability and high yield.

Of course, the invention may also be applied to a MIS type semi-conductor device.

## Claims

1. A method of manufacturing a semi-conductor device comprising:
a) providing a semi-conductor substrate (101) of a first conductivity type;
b) forming a gate electrode on the semi-conductor substrate including a first conductive layer (103) and a second conductive layer (105) superposed thereon, said first conductive layer (103) including polysilicon material and said second conductive layer including refractory metal;
c) ion-implanting impurities of a second conductivity type into the semi-conductor substrate to form source/drain regions using the first and second conductive layer as a mask; and
characterised in that between steps (b) and (c) thermal annealing is performed to contract the second conductive layer relative to the first conductive layer.

2. A method as claimed in claim 1 characterised in that the second conductive layer is molybdenum and the thermal annealing is carried out at a temperature of between 850°C and 1100°C.

3. A method according to claim 1 or claim 2 characterised in that the second conductive layer reacts to produce a refractory metal silicide during the thermal annealing.

4. A method according to any one of claims 1 to 3 characterised in that the step of ion implanting using the first and second conductive layers as a mask includes selecting the kind of ions and setting the ion implantation acceleration energy so as to transmit ions through the first conductive layer but not through both the first and the second conductive layers.

5. A method according to any preceding claim characterised in that the step of ion implanting using the first and second conductive layers as a mask is arranged to produce a first ion implanted region of lesser depth beneath a peripheral area of the first conductive layer, and a second ion implanted region of greater depth beyond the first conductive layer.

6. A method according to any preceding claim characterised in that the step of forming source/drain regions includes forming a side wall insulating film (107) on the first and second conductive layers, and ion implanting impurities of the second type using the first and second conductive layers and the side wall insulating film as a mask.

## Patentansprüche

1. Verfahren zum Herstellen eines Halbleiterbauelements, umfassend:
a) Bereitstellen eines Halbleitersubstrats (101) eines ersten Leitfähigkeitstyps;
b) Bilden einer Gateelektrode auf dem Halbleitersubstrat, umfassend eine erste leitfähige Schicht (103) und eine hierauf angeordnete zweite leitfähige Schicht (105), wobei die erste leitfähige Schicht (103) ein Polysiliziummaterial umfaßt und die zweite leitfähige Schicht ein hitzefestes Metall umfaßt;
c) lonenimplantieren von Fremdatomen eines zweiten Leitfähigkeitstyps in das Halbleitersubstrat, um unter Verwendung der ersten und der zweiten leitfähigen Schicht als eine Maske Source/Drain-Bereiche zu bilden; und
**dadurch gekennzeichnet**, daß zwischen den Schritten (b) und (c) ein Tempern durchgeführt wird, um die zweite leitfähige Schicht relativ zur ersten leitfähigen Schicht zu schrumpfen.

2. Verfahren nach Anspruch 1, dadurch gekennzeichnet, daß die zweite leitfähige Schicht Molybdän ist und daß das Tempern bei einer Temperatur zwischen 850°C und 1100°C durchgeführt wird.

3. Verfahren nach Anspruch 1 oder 2, dadurch gekennzeichnet, daß die zweite leitfähige Schicht reagiert, um während des Temperns ein hitzefestes-Metall-Silizid zu erzeugen.

4. Verfahren nach einem der Ansprüche 1 bis 3, dadurch gekennzeichnet, daß der Schritt des lonenimplantierens unter Verwendung der ersten und zweiten leitfähigen Schicht als eine Maske die Wahl der Art von lonen und das Einstellen der lonenimplantations-Beschleunigungsenergie derart umfaßt, daß lonen durch die erste leitfähige Schicht, nicht aber durch sowohl die erste als auch die zweite leitfähige Schicht, durchgelassen werden.

5. Verfahren nach einem der vorangehenden Ansprüche, dadurch gekennzeichnet, daß der Schritt des lonenimplantierens unter Verwendung der ersten und der zweiten leitfähigen Schicht als eine Maske dazu ausgelegt ist, eine erste ionenimplantierte Region geringerer Tiefe unterhalb eines Randabschnitts der ersten leitfähigen Schicht sowie eine zweite ionenimplantierte Region größerer Tiefe jenseits der ersten leitfähigen Schicht zu erzeugen.

6. Verfahren nach einem der vorangehenden Ansprüche, dadurch gekennzeichnet, daß der Schritt des Bildens von Source/Drain-Bereichen das Bilden eines isolierenden Seitenwandfilms (107) auf der ersten und der zweiten leitfähigen Schicht sowie das lonenimplantieren von Fremdatomen des zweiten Typs unter Verwendung der ersten und der zweiten leitfähigen Schicht und des isolierenden Seitenwandfilms als eine Maske umfaßt.

## Revendications

1. Procédé de fabrication d'un composant à semiconducteur comprenant :
a) la réalisation d'un substrat semiconducteur (101) d'un premier type de conductivité ;
b) la formation d'une électrode de grille sur le substrat semiconducteur comprenant une première couche conductrice (103) et une seconde couche conductrice (105) superposée sur cette dernière, ladite première couche conductrice (103) comprenant une matière de polysilicium et ladite seconde couche conductrice comprenant un métal réfractaire ;
c) l'implantation ionique d'impuretés d'un second type de conductivité dans le substrat semiconducteur pour former des zones source/drain en utilisant les première et seconde couches conductrices en tant que masque ; et
caractérisé en ce que, entre les étapes (b) et (c), un recuit thermique est effectué pour contracter la seconde couche conductrice par rapport à la première couche conductrice.

2. Procédé selon la revendication 1, caractérisé en ce que la seconde couche conductrice est du molybdène et le recuit thermique est exécuté à une température comprise entre 850 °C et 1 100 °C.

3. Procédé selon la revendication 1 ou la revendication 2, caractérisé en ce que la seconde couche conductrice réagit pour produire un métal réfractaire à base de siliciures pendant le recuit thermique.

4. Procédé selon l'une quelconque des revendications 1 à 3, caractérisé en ce que l'étape d'implantation ionique utilisant les première et seconde couches conductrices en tant que masque comprend la sélection du type d'ions et la fixation de l'énergie d'accélération d'implantation ionique de façon à transmettre des ions à travers la première couche conductrice mais pas, à la fois, à travers la première et la seconde couches conductrices.

5. Procédé selon l'une quelconque des revendications précédentes, caractérisé en ce que l'étape d'implantation ionique utilisant les première et seconde couches conductrices en tant que masque est conçue pour produire une première zone, ayant des ions implantés, de profondeur moindre au-dessous d'une surface périphérique de la première couche conductrice, et une seconde zone, ayant des ions implantés, de profondeur supérieure au-delà de la première couche conductrice.

6. Procédé selon l'une quelconque des revendications précédentes, caractérisé en ce que l'étape de formation de zones source/drain comprend la formation d'un film isolant de paroi latérale (107) sur les première et seconde couches conductrices, et l'implantation ionique d'impuretés du second type en utilisant les première et seconde couches conductrices et le film isolant de paroi latérale en tant que masque.
